Europäisches Patentamt

European Patent Office

Office européen des brevets

(19)

(11) Veröffentlichungsnummer: 0 153 492

A1

# (12) EUROPÄISCHE PATENTANMELDUNG

(21) Anmeldenummer: 84116254.8

(22) Anmeldetag: 22.12.84

(51) Int. Cl.⁴: **H 03 K 5/08**
**H 02 H 9/04**

(30) Priorität: 08.02.84 DE 3404317

(43) Veröffentlichungstag der Anmeldung:
04.09.85 Patentblatt 85/36

(84) Benannte Vertragsstaaten:
DE FR GB IT

(71) Anmelder: ROBERT BOSCH GMBH
Postfach 50
D-7000 Stuttgart 1(DE)

(72) Erfinder: Aberle, Thomas
Breslauer Strasse 49
D-7014 Kornwestheim(DE)

(72) Erfinder: van Belzen, David, Dipl.-Ing.
Hochstetterstrasse 24
D-7251 Hemmingen(DE)

(72) Erfinder: Krauter, Immanuel, Dipl.-Ing.
Haupstrasse 26
D-7151 Erbstetten(DE)

(54) Schutzschaltung für durch elektrische Signale gesteuerte Geräte.

(57) Es wird eine Schutzschaltung für durch elektrische Signale, insbesondere analoge Signale, gesteuerte Geräte vorgeschlagen, deren Eingang (3) gegen positive und/oder negative Überspannung gegenüber einer oberen Bezugsspannung (1) und/oder unteren Bezugspannung (2) gesichert wird. Durch eine Kollektorstromregelung des Transistors (12) am Eingang (3) durch drei Transistoren (11, 13, 14) wird das Potential des Eingangs (3) auf dem Bezugspannungspotential gehalten, solange eine treibende Schaltung eine Überspannung liefert. Eine dual aufgebaute Schaltung (21 bis 24) bietet die Sicherung gegenüber einer negativen Überspannung. Durch eine symmetrische Schaltungsstruktur wird ein guter Temperaturgang erreicht. Die Schutzschaltung kann leicht innerhalb eines integrierten Schaltkreis integriert werden.

EP 0 153 492 A1

R. 19199
2.2.1984 Ko/Hm

0153492

ROBERT BOSCH GMBH, 7000 STUTTGART 1

Schutzschaltung für durch elektrische Signale gesteuerte Geräte

## Stand der Technik

Die Erfindung geht aus von einer Schutzschaltung für
durch elektrische Signale, insbesondere analoge Signale, gesteuerte Geräte nach der Gattung des Hauptanspruches.

Aus der DE-OS 32 40 280 ist bereits eine Schutzschaltung für Analog- und Digitalsignale bekannt. Diese Analog- und Digitalsignale sind für einen Eingang eines
durch elektrische Signale gesteuerten Gerätes bestimmt,
das gegen positive und/oder negative Überspannung am
Eingang durch die Schutzschaltung gesichert wird. Problematisch an einer solchen Schutzschaltung ist eine
Nichtlinearität des Eingangswiderstandes des zu schützenden Gerätes von ca. 100 Millivolt pro Stromdekade
des Eingangsstromes. Damit verbunden ist eine starke
Temperaturabhängigkeit des Eingangswiderstandes, die
eine Verfälschung etwa eines Meßergebnisses bewirken
kann.

. . .

Vorteile der Erfindung

Die erfindungsgemäße Schutzschaltung nach der Gattung
des Hauptanspruches hat demgegenüber den Vorteil, einen großen Spannungsbereich ohne Strombeeinflussung
des Einganges des Gerätes zu besitzen. Im Arbeitspunkt
ist ein sehr linearer und flacher Verlauf der Begrenzungsgeraden erreicht. Am Begrenzungspunkt, d.h. an
der Begrenzungsspannung liegt ein sehr scharfer, temperaturunabhängiger Knick der Strom-Spannungs-Kennlinie vor. Damit kann der Aussteuerbereich des Gerätes,
insbesondere eines Analog-Digital-Wandlers, bis auf
einige 10 Millivolt an die Begrenzungsspannung herangeführt werden. Von weiterem Vorteil ist es, daß die gesamte Schutzschaltung lediglich aus Halbleiterelementen
besteht, und somit leicht integrierbar ist, so daß die
Erfindung weite Anwendungsfelder im Bereich der integrierten Schaltkreise findet.

Durch die in den Unteransprüchen aufgeführten Maßnahmen
sind vorteilhafte Ausführungen der Erfindung möglich.
Die erfindungsgemäße Schutzschaltung läßt sich in einfachster Weise in eine duale Struktur umformen, so daß
eine Schutzschaltung zum Schutz gegen Überspannungen
über eine obere Bezugsspannung in eine Schutzschaltung
zum Schutz gegen Überspannungen unterhalb einer unteren
Bezugsspannung umgeformt wird. Dabei ist es bei diskreten
Schaltungsaufbauten vorteilhaft, die Stromquellen beider
Schutzschaltungen durch einen einzigen gemeinsamen,
hochohmigen Widerstand zu ersetzen. Bei einer Integration der Schaltung sind jedoch Stromquellen weniger
flächenintensiv als hochohmige Widerstände.

...

Zeichnung

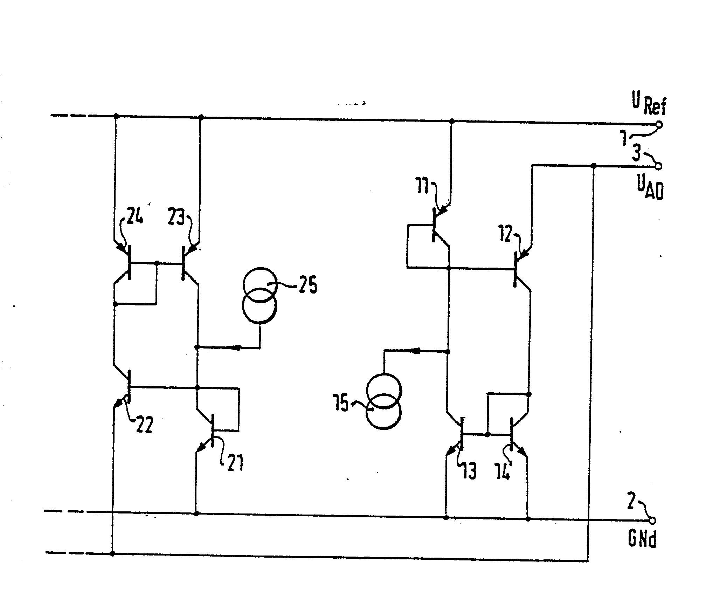

Ein Ausführungsbeispiel der Erfindung ist in der Zeichnung dargestellt und in der nachfolgenden Beschreibung
näher erläutert. In der Zeichnung ist eine schaltungstechnische Ausgestaltung einer erfindungsgemäßen Schutzschaltung am Eingang eines nicht näher dargestellten,
durch elektrische Signale gesteuerten, Gerätes dargestellt.

Beschreibung des Ausführungsbeispieles

Die Zeichnung zeigt zwei Bezugsspannungen: An einer
Klemme 1 liegt die erste Bezugs-Spannung $U_{ref}$ und an
einer Klemme 2 die zweite Bezugsspannung Gnd. An eine
Klemme 3 ist eine Eingangsspannungs $U_{AD}$ angelegt, die
zur Verarbeitung in einem nicht näher dargestellten Analog-
Digital-Wandler anliegt. Die beiden Bezugsspannungen $U_{ref}$
und Gnd führen ebenfalls zum Analog-Digital-Wandler.
Das Ausführungsbeispiel weist zwei Schaltungshälften
auf, die rechte Hälfte in der Zeichnung mit den Bauteilen 11 bis 15 dient zum Schutz gegen Überspannungen,
die die erste Bezugsspannung $U_{ref}$ übersteigen, die
linke Schaltungshälfte mit den Bauteilen 21 bis 25
ist dual symmetrisch zur rechten Schaltungshälfte aufgebaut und dient zum Schutz gegen Spannungen, die an
der Klemme 3 anliegen und die zweite Bezugsspannung
Gnd unterschreiten.

Ein erster Transistor 11 und ein zweiter Transistor
12 sind vom pnp-Typ und mit der Basis zusammengeschlossen. Der Emitter des Transistors 11 liegt an der Klemme 1, der Kollektor und die Basis sind zusammengeschlos-

...

sen. Der Emitter des Transistors 12 führt an die Klemme 3. Zwei npn-Transistoren 13, 14 sind ebenfalls mit der Basis zusammengeschlossen. Der Kollektor des Transistors 14 ist mit seiner Basis und mit dem Kollektor des Transistors 12 verbunden. Der Kollektor des Transistors 13 führt an den Kollektor des Transistors 11 und an eine Stromquelle 15. Die Emitter der Transistoren 13, 14 führen an die Klemme 2.

Insgesamt besteht die Schaltung aus zwei übereinandergeschalteten komplementären Stromspiegeln, wie sie u.a. aus der Zeitschrift "Funkschau", 26/1983, Seiten 44 ff, bekannt sind. Dabei stellt im unteren Stromspiegel der Transistor 14 einen Eingangs- und der Transistor 13 einen Ausgangstransistor dar; entsprechend ist im oberen Stromspiegel der Transistor 11 ein Eingangs- und der Transistor 12 ein Ausgangstransistor.

Die linke Schaltungshälfte zeigt eine duale Schaltungsstruktur zur rechten, wobei npn- in pnp-Typen übergeführt sind. Ebenfalls sind in dualer Weise die beiden Bezugsspannungen topologisch vertauscht. Ansonsten weist die Schutzschaltung auf der linken Hälfte der Zeichnung neben der dualen Struktur auch ein entsprechendes elektrisches Verhalten auf, so daß im nachfolgenden nur die rechte Schaltungsstruktur erläutert wird. Dabei ist zur Vereinfachung der Beschreibung die Bezifferung so gewählt, daß für den Transistor 11 der duale Transistor die Bezifferung 21 erhält, für den Transistor 12 der duale Transistor die Bezifferung 22 etc.

...

0153492

Im Normalbetrieb, d.h. $U_{ref} > U_{AD} > $ Gnd fließt
durch den Transistor 11 ein Ruhestrom in der Größenordnung von einigen Mikroampere in die Stromquelle
15 ab. Dadurch wird an der Basis des Transistors 12
eine Vorspannung erzeugt. Die Transistoren 13, 14
sind gesperrt.

Nähert sich $U_{AD}$ die Eingangsspannung der Bezugs-Spannung
$U_{ref}$ auf einige Millivolt, so wird der Transistor 12 leitend. Dabei fließt ein Eingangsstrom von der Klemme 3 in
den Transistor 12, und damit als Kollektorstrom in einen
Stromspiegel, der aus den Transistoren 13, 14 gebildet
wird. Damit hat der Kollektorstrom des Transistors 13
dieselbe Größe wie der des Transistors 12. Diese Stromspiegelung bewirkt eine Erhöhung der Emitter-Kollektor-
Spannung am Transistor 11, so daß das Emitterpotential
des Transistors 12, und damit das Eingangspotential an
der Klemme 3, unabhängig vom Eingangsstrom die Bezugs-
Spannung $U_{ref}$ nicht überschreiten kann. Durch die Transistoren 11, 13, 14 wird somit eine Spannungsregelung an
der Klemme 3 über den Eingangsstrom durchgeführt, solange
die Ausgangsspannung einer an der Klemme 3 angeschlossenen
treibenden Schaltung größer als $U_{ref}$ ist. Der Eingangsstrom in die Klemme 3 wird somit lediglich durch
den Ausgangswiderstand der treibenden Schaltung bestimmt.

Die symmetrische Struktur der Transistoren 11, 12 zu
den Transistoren 13, 14 bewirkt eine ausgezeichnete
Temperaturkompensation der Begrenzerschwelle bei einer
Temperaturdrift des Eingangsstromes von weniger als
etwa 0,2 uA/$100^{\circ}$ C.

...

0153492

Die erfindungsgemäße Schutzschaltung ist in einfacher Weise integrierbar innerhalb eines integrierten Schaltkreises. Darin stellen auch die Realisierung der Stromquellen 15, 25 keine Probleme dar. Die beiden Stromquellen 15, 25 können aber auch in einfacher Weise durch einen einzigen hochohmigen Widerstand in der Größenordnung von einem Megaohm ersetzt werden, wobei dieser Widerstand zwischen den Kollektor des Transistors 13 und den Kollektor des Transistors 23 geschaltet wird. Innerhalb eines integrierten Bausteines kann dieser Widerstand etwa als Feldeffekttransistor realisiert werden. Im Rahmen der Erfindung liegt selbstverständlich die Verwendung von Transistoren mit Mehrfach-Emittern, um etwa den Spiegelfaktor zu ändern. Zur Erhöhung der Grenzfrequenz der Schutzschaltung werden in vorteilhafter Weise schnelle pnp-Strukturen verwendet.

R. 19199

2.2.1984 Ko/Hm

ROBERT BOSCH GMBH, 7000 STUTTGART 1

Ansprüche

1. Schutzschaltung für durch elektrische Signale gesteuerte Geräte, deren Eingang (3) gegen eine Überspannung gegenüber einer ersten Bezugsspannung ($U_{Ref}$) durch die Schutzschaltung gesichert wird, dadurch gekennzeichnet, daß die Schutzschaltung aus zwei übereinander durchgeschalteten komplentären Stromspiegeln besteht, daß die Emitter des ersten Stromspiegels (13, 14) an einer zweiten Bezugsspannung (GND) liegen, daß der Emitter des Ausgangstransistors (12) des zweiten Stromspiegels (11, 12) am Eingang (3) liegt, und daß der Emitter des Eingangstransistors (11) des zweiten Stromspiegels (11, 12) an der ersten Bezugsspannung ($U_{Ref}$) liegt.

2. Schutzschaltung nach Anspruch 1, dadurch gekennzeichnet, daß eine erste Schutzschaltung (11, 12, 13, 14) gegen eine positive Überspannung gegenüber der ersten Bezugsspannung ($U_{Ref}$) vorgesehen, daß eine zweite, zur ersten duale, Schutzschaltung (21, 22, 23, 24) gegen eine negative Überspannung gegenüber der zweiten Bezugsspannung (GND) vorgesehen ist, und daß die erste Schutzschaltung parallel zur zweiten Schutzschaltung geschaltet ist.

. . .

19 19 0153492

3. Schutzschaltung nach Anspruch 1 oder 2, dadurch gekennzeichnet, daß an den Kollektor des Eingangstransistors (11) des zweiten Stromspiegels (11, 12) eine Stromquelle (15) angeschlossen ist.

4. Schutzschaltung nach Anspruch 3, dadurch gekennzeichnet, daß die Stromquelle (15) durch einen hochohmigen Widerstand oder durch wenigstens ein Halbleiterelement, vorzugsweise ein Feldeffekttransistor, gebildet wird.

5. Schutzschaltung nach einem der vorhergehenden Ansprüche, dadurch gekennzeichnet, daß die Stromspiegel mit Transistoren mit Mehrfach-Emittern ausgestattet sind.

6. Schutzschaltung nach einem der vorhergehenden Ansprüche, dadurch gekennzeichnet, daß die Schutzschaltung integriert ist.

### Europäisches Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 268 789 (K. NAGANO) * Spalte 1, Zeile 57 - Spalte 2, Zeilen 3, 38-64; Figuren 5,12 * | 1 | H 03 K 5/08 H 02 H 9/04 |
| A | | 2 | |
| | --- | | |
| Y | US-A-4 027 177 (W.F. DAVIS) * Spalte 2, Zeilen 23-39; Figur 2 * | 1 | |
| A | * Figur 1 * | 6 | |
| | --- | | |
| D,A | FUNKSCHAU, Heft 26, 1983, München; H. SCHREIBER "Kennen Sie Stromspiegel?", Seiten 44-47 * Seiten 44-47 * | 1-6 | |
| P,D A | DE-A-3 240 280 (R. BOSCH GMBH) * Figuren 1,2 * | | |

| RECHERCHIERTE SACHGEBIETE (Int. Cl.4) |
|---|
| H 02 H 9/04 |
| H 03 K 5/01 |
| H 03 K 5/08 |
| H 03 K 17/16 |
| H 03 K 17/30 |

Der vorliegende Recherchenbericht wurde für alle Patentansprüche erstellt.

| Recherchenort | Abschlußdatum der Recherche | Prüfer |
|---|---|---|
| BERLIN | 06-05-1985 | LEMMERICH J |